# EUROPÄISCHE PATENTSCHRIFT

(11) **EP 2 162 815 B1**
(45) Veröffentlichungstag und Bekanntmachung des Hinweises auf die Patenterteilung: **01.05.2013**
(21) Anmeldenummer: 08773467.9
(22) Anmeldetag: 16.06.2008
(51) Int. Cl.: G05F 3/26, H01L 27/088, H01L 27/02

(54) **HALBLEITERBAULEMENT MIT VERSCHACHTELTEN KONTAKTEN**
SEMICONDUCTOR COMPONENT WITH NESTED CONTACTS
COMPOSANT SEMICONDUCTEUR À CONTACTS IMBRIQUÉS

(30) Priorität: 18.06.2007 DE 102007028461; 18.06.2007 DE 102007028459
(43) Veröffentlichungstag der Anmeldung: 17.03.2010
(73) Patentinhaber: Microgan Gmbh, 89081 Ulm (DE)
(72) Erfinder: DAUMILLER, Ingo, 89165 Dietenheim/Regglisweiler (DE); SÖNMEZ, Ertugrul, 89075 Ulm (DE); KUNZE, Mike, 89284 Pfaffenhoffen (DE)
(74) Vertreter: Pfenning, Meinig & Partner GbR
(86) Internationale Anmeldenummer: PCT/EP2008/004836
(87) Internationale Veröffentlichungsnummer: WO 2008/155083

(56) Entgegenhaltungen:
- EP-A- 0 348 998
- EP-A- 0 507 077
- EP-A- 1 380 418
- EP-A- 1 420 450
- WO-A-2005/079293
- JP-A- 2004 281 467
- US-A1- 2005 051 853
- US-A1- 2006 214 693
- US-A1- 2008 073 728
- US-B1- 6 424 006

## Beschreibung

Die Erfindung betrifft ein Halbleiterbauelement mit zumindest einer Baueinheit, welche eine Vielzahl von gleichartigen Untereinheiten mit jeweils zumindest zwei Kontakten verschiedener Funktionen aufweist, die abwechselnd nebeneinander angeordnet sind. Die Erfindung betrifft außerdem ein Verfahren zur Herstellung eines solchen Halbleiterbauelementes.

Um Halbleiterbauelemente bei höheren Leistungen betreiben zu können, wird normalerweise die Bauelementweite erhöht. Um dabei den parasitären Serienwiderstand von Kontaktierungen oder Elektroden des Bauelementes zu reduzieren, wird das Bauelement in mehrere schmalere Untereinheiten aufgeteilt, die dann über einen sog. Bus parallel geschaltet werden. Hierzu werden Kontakte gleicher Funktion von unterschiedlichen Untereinheiten über den Bus elektrisch miteinander kontaktiert.

Das Halbleiterbauelement kann beispielsweise eine halbe H-Brücke sein. Eine solche halbe H-Brücke weist im Allgemeinen zwei Transistoren auf, die zueinander in Serie geschaltet sind, d.h. dass ein Source-Kontakt eines ersten der Transistoren mit einem Drain-Kontakt eines zweiten der Transistoren elektrisch verbunden ist. Die Gate-Kontakte des ersten und des zweiten Transistors sind unabhängig voneinander ansprechbar.

Bei der Aufteilung in mehrere Untereinheiten ist dann jede dieser Untereinheiten eine derartige halbe H-Brücke. Es sind dabei die Drain-Kontakte aller ersten Transistoren miteinander verbunden, die Gate-Kontakte aller ersten Transistoren miteinander verbunden sowie die Source-Kontakte aller ersten Transistoren miteinander verbunden und für die zweiten Transistoren entsprechend. Die Gesamtheit der Untereinheiten wirkt daher wie eine halbe H-Brücke. An dem Source-Kontakt des ersten Transistors und dem Drain-Kontakt des zweiten Transistors kann ein Verbraucher angeschlossen sein.

Nach dem Stand der Technik wurde das Halbleiterbauelement aus einer Vielzahl von Untereinheiten zusammengesetzt, indem auf einer Oberfläche des Halbleiterbauelementes sämtliche Drain-Kontakte der ersten Transistoren und sämtliche Source-Kontakte der zweiten Transistoren nebeneinander angeordnet wurden. Hierbei waren auf einer Hälfte der Oberfläche alle Drain-Kontakte der ersten Transistoren und auf der anderen Hälfte alle Source-Kontakte der zweiten Transistoren aneinander angrenzend nebeneinander angeordnet. Beispiele für den Stand der Technik sind die ßruchschriften US 2006/0214693 und US 2005/0051853.

Soll ein derartiges Bauelement bei hohen Leistungen betrieben werden, so ergibt sich das Problem, dass sich das Halbleiterbauelement und die Kontakte stark erwärmen. Hierdurch steigt auch der thermische Widerstand der Kontakte, was wiederum zu einer weiteren Erwärmung führt.

Aufgabe der vorliegenden Erfindung ist es daher, das Prinzip, ein Bauelement in mehrere Untereinheiten aufzuteilen, auch bei höheren Leistungen zu ermöglichen, ohne dass hierbei der unerwünschte Serienwiderstand zu sehr ansteigt.

Diese Aufgabe wird gelöst durch das Halbleiterbauelement nach Anspruch 1, sowie das Verfahren zur Herstellung eines Halbleiterbauelementes nach Anspruch 15. Vorteilhafte Weiterbildungen des erfindungsgemäßen Halbleiterbauelementes und des Herstellungsverfahrens werden durch die jeweiligen abhängigen Ansprüche gegeben.

Erfindungsgemäß ist ein Halbleiterbauelement mit zumindest einer Baueinheit, welche eine Vielzahl von gleichartigen Untereinheiten aufweist. Gleichartig bedeutet, dass die Untereinheiten gleich aufgebaut sind und vorzugsweise auch die gleichen Abmessungen haben. Vorzugsweise sind die Untereinheiten zusammen auf einem gemeinsamen Substrat ausgebildet.

Jede der gleichartigen Untereinheiten hat Kontakte mit zumindest zwei verschiedenen Funktionen. Die Untereinheiten können Dioden, Widerstände, Spulen oder Kondensatoren sein. In diesem Fall haben die Untereinheiten jeweils zwei Kontakte, wobei die zwei Funktionen den Polen der Kontakte entsprechen. Die Untereinheiten können auch Transistoren sein. In diesem Fall sind die Funktionen der Kontakte Source, Drain und Gate oder Kollektor, Emitter und Basis oder bei anderen Transistortypen entsprechende Kontakte. Die Untereinheiten können auch wie oben beschrieben ausgestaltete halbe H-Brücken sein. In diesem Falle sind die Kontakte unterschiedlicher Funktionen der Drain-Kontakt der ersten Transistoren, der Source-Kontakt der zweiten Transistoren, der Gate-Kontakt der ersten Transistoren und die Gate-Kontakte der zweiten Transistoren.

Erfindungsgemäß sind die Kontakte zumindest zweier verschiedener Funktionen auf einer gemeinsamen Fläche und/oder in einer gemeinsamen Ebene nebeneinander angeordnet. Die genannten Aufgaben lassen sich nun insbesondere dadurch lösen, dass hierbei unmittelbar benachbart zu jedem Kontakt einer Funktion zumindest ein Kontakt einer anderen Funktion angeordnet ist. Unmittelbar benachbart bedeutet hier, dass zwischen einem Kontakt und dem unmittelbar benachbarten Kontakt kein anderer Kontakt angeordnet ist. Es ist bevorzugt, wenn die benachbarten Kontakte auch unmittelbar aneinander angrenzen, was bedeutet, dass sie abgesehen von einer eventuellen Isolationsschicht oder einem Isolationsbereich räumlich direkt nebeneinander liegen. Durch eine solche Anordnung wird erreicht, dass ein Strom, der durch einen Kontakt einer Funktion fließt, über eine möglichst große Fläche einer Oberfläche des Halbleiterbauelementes verteilt in das Halbleiterbauelement fließt. Dies ist insbesondere bei Untereinheiten oder Baueinheiten von Vorteil, bei welchen durch die Kontakte verschiedener Funktionen nicht gleichzeitig, sondern nacheinander und/oder abwechselnd Strom im Betrieb fließt oder nicht durch Kontakte aller Funktionen die gleiche Stromstärke fließt.

Besonders bevorzugt ist eine Anordnung der Kontakte, bei welchen ein Kontakt einer ersten Funktion neben einem Kontakt einer zweiten Funktion liegt, welcher neben einem weiteren Kontakt der zweiten Funktion liegt. Neben dem weiteren Kontakt der zweiten Funktion liegt dann auf der anderen Seite wieder ein Kontakt der ersten Funktion, neben welchem dann ein weiterer Kontakt der ersten Funktion liegt. Eine Isolierung ist hierbei vorzugsweise zwischen Kontakten unterschiedlicher Funktionen oder zwischen allen Kontakten angeordnet. Das genannte Muster kann über die gesamte Bauelementausdehnung fortgesetzt werden. In einer Ausführungsform der Erfindung können die Kontakte als längliche parallele Streifen nebeneinander angeordnet sein.

Vorteilhafterweise sind die Kontakte-länglich ausgebildet, d.h. sie haben entlang einer geraden oder gekrümmten Linie eine im Wesentlichen konstante Ausdehnung senkrecht zu dieser Linie. Die lokale Richtung der Linie ist dann die Längsrichtung der Kontakte. Bevorzugt ist, dass zumindest einige der Kontakte parallel zueinander angeordnet sind. Parallel bedeutet hier, dass die Kontakte einen konstanten kleinsten Abstand, beispielsweise entlang ihrer Längsrichtung, zueinander haben. Besonders bevorzugt sind hierbei entlang von Geraden ausgedehnte Kontakte. Vorzugsweise sind die Kontakte außerdem auf einem Substrat angeordnet, welches besonders bevorzugt leitend oder halbleitend ist. Insbesondere können die Kontakte auf einem gemeinsamen Substrat ausgebildet sein. Das Substrat kann auch in die Funktion des entsprechenden Bauelementes oder der Untereinheiten eingebunden sein.

In einer besonders bevorzugten Ausführungsform ist zumindest ein Teil der Kontakte ringförmig ausgestaltet, d.h. dass die Kontakte wie oben beschrieben länglich sind und in ihrer Längsrichtung geschlossen sind. Die Ringform kann hierbei einen Kreisring beschreiben oder aber auch eine Ellipse, ein Quadrat, ein Rechteck, ein Dreieck oder andere geometrische Formen. Hierdurch kann der unerwünschte Serienwiderstand weiter verringert werden.

In einer bevorzugten Ausführungsform ist die Baueinheit des Halbleiterbauelementes so ausgestaltet, dass im Betrieb nur durch Kontakte mit einigen, vorzugsweise einer der Funktionen zu einem bestimmten Zeitpunkt ein Strom fließt. Durch welche der Kontakte der Strom fließt, kann mit der Zeit variieren. In dieser Ausgestaltung ist die erfindungsgemäße abwechselnde Anordnung der Kontakte besonders vorteilhaft, da stets die gesamte Oberfläche des Bauelementes zur Aufnahme der Wärme und zur Abstrahlung der Wärme zur Verfügung steht.

Dies ist beispielsweise bei einer H-Brücke der Fall, welche aus zwei der oben beschriebenen halben H-Brücken zusammengesetzt ist. Hierbei ist jeweils eine halbe H-Brücke an einen Pol eines Verbrauchers angeschlossen. Über die Drain-Kontakte der ersten Transistoren der beiden halben H-Brücken einerseits und über die Source-Kontakte der zweiten Transistoren der beiden H-Brücken andererseits wird eine Versorgungsspannung angelegt. Durch Öffnen des ersten Transistors der ersten halben H-Brücke und Öffnen des zweiten Transistors der zweiten halben H-Brücke kann ein Strom in einer Richtung durch den Verbraucher geleitet werden. Wird hingegen der erste Transistor der zweiten halben H-Brücke und der zweite Transistor der ersten halben H-Brücke geöffnet, so fließt der Strom in entgegengesetzter Richtung durch den Verbraucher. Bei zwei halben H-Brücken können alle vier Kontakte, an welche die Versorgungsspannung angelegt wird, auf einem Substrat und/oder in einer Ebene angeordnet sein, es ist aber auch möglich, jeweils eine halbe H-Brücke auf einem einzelnen Substrat anzuordnen. Im ersten Fall ist das Halbleiterbauelement eine vollständige H-Brücke, im zweiten Fall liegen zwei der erfindungsgemäßen Halbleiterbauelemente mit jeweils einer halben H-Brücke vor. Auch kann jeweils eine halbe H-Brücke eine der Baueinheiten sein.

Als Transistoren eignen sich besonders bevorzugt Feldeffekttransistoren. Für einen Betrieb bei hohen Leistungen ist es außerdem bevorzugt, wenn das Bauelement, die Baueinheit oder die Untereinheiten zumindest einen Halbleiter aufweisen, welcher ein Nitrid eines Hauptgruppe-III-Elementes enthält oder daraus besteht. Besonders bevorzugt sind hierbei Halbleiter, welche die Elemente Ga, In und Al aufweisen. Beispielhaft seien hier GaN, InN, AlN, GaAlN, GaInN und GaAlInN genannt.

Die genannten Halbleitermaterialien haben den Vorteil, dass mit ihnen eine Schaltung realisierbar ist, die besonders resistent gegen hohe Temperaturen, insbesondere gegen Temperaturen ≥ 100 °C, besonders bevorzugt ≥ 300 °C, besonders bevorzugt ≥ 500 °C, besonders bevorzugt ≥ 700 °C sind.

Es ist bevorzugt, wenn zumindest eines der oben genannten Baueinheiten mit den genannten Hauptgruppe-III-Halbleitern zumindest einen Transistor aufweist. Besonders bevorzugt sind jeweils Transistoren, welche eine n-Kanalleitfähigkeit und/oder selbstleitende Eigenschaften besitzen, da diese Transistoren sich mit den oben beschriebenen Hauptgruppe-III-basierenden Materialsystemen relativ einfach herstellen lassen.

Ein solcher Transistor kann eine Quelle oder Source, eine Senke oder Drain sowie ein Gate aufweisen. Besonders vorteilhaft lassen sich hier Feldeffekttransistoren (FET), insbesondere Sperrschicht-Feldeffekttransistoren (RFET) realisieren.

Vorteilhafterweise können die folgenden Transistortypen zum Einsatz kommen. Zum einen können Heterostruktur-Transistoren, wie HEMT oder HFET, MODFET oder MOSHFET verwendet werden. In solchen Transistoren wird ein leitfähiger Kanal im Wesentlichen dadurch erzeugt, dass zwei Hauptgruppe-III-Nitrid-basierende Schichten aufgrund ihrer Verspannungen zueinander (Polarisationseffekt) einen leitfähigen Kanal aus einem zweidimensionalen Elektronengas (2DEG) an ihrer Grenzfläche erzeugen. Hierdurch entsteht im Kanal Leitfähigkeit ohne äußere Dotierung. Zur Herstellung solcher Transistoren wird auf einem Substrat zunächst eine (Al)(Ga)(In)-N-basierende Schicht, der sog. Puffer, aufgebracht, auf dem dann wiederum eine dünne (Al)(Ga)(In)-N-basierende Schicht aufgebracht wird. Mit Hilfe von zwei Ohmschen Kontakten (Source und Drain) kann dann das zweidimensionale Elektronengas kontaktiert werden. Die Steuerung der Ladungsträger bzw. eine Modellation der Dichte der Ladungsträger kann hier durch ein Gate erfolgen, das zwischen den Ohmschen Kontakten angeordnet ist. Ein Beispiel für einen solchen Transistor ist ein AlGaN/GaN HEMT. Hier ist dann GaN der Puffer, während das Substrat z.B. Silizium sein kann.

Derartige Heterostrukturen können auf verschiedene Weise abgewandelt sein. Es können z.B. die einzelnen Schichten unterschiedlich dotiert sein oder nur partiell in Dotierspikes dotiert sein, wie z.B. beim MODFET. Darüberhinaus ist es möglich, dass unter der Gate-Diode ein Isolator platziert ist. Man spricht dann von einem sog. MOS (Metal Oxide Semiconductor), MIS (Metal Isolation Semiconductor) Transistor oder HEMT. Dieser wird bei GaN auch MOSHFET genannt.

Vorzugsweise sind diese Transistortypen selbstleitend (normally-on), d.h. bei einer Gatespannung von 0 V bzw. bei keiner angelegten Spannung am Gate fließt ein Strom zwischen Source und Drain.

Prinzipiell ist es aber möglich, mit GaN und deren Verbindungen normally-off, d.h. selbstsperrende Transistoren herzustellen. Dabei wird in der Schichtfolge die Zusammensetzung der Materialien (mit In, Ga, Al oder N) zueinander angepasst, so dass bei fehlender Gate-Spannung zwischen Source und Drain kein Strom fließt. Ein Stromfluss ergibt sich dann, wenn das Gate, z.B. bei einem n-Typ Transistor zu positiven Werten angesteuert wird.

Eine weitere Möglichkeit, einen selbstsperrenden Transistor zu realisieren, besteht darin, bei einem klassischen selbstleitenden Transistor unter dem Gatemetall die darunterliegende Halbleiterschicht zu ätzen (z.B. in das AlGaN), so dass diese Schicht unter dem Gate dünner wird (es entsteht ein Gate-Recess). Bei einer geeigneten Dicke kann dann ein selbstsperrender Transistor entstehen.

Eine andere Klasse von Transistoren sind Transistoren ohne Heterostruktur, wie beispielsweise MESFET oder delta-doped MESFET. Die Leitfähigkeit dieser Transistoren wird durch eine Dotierung im Volumenmaterial von (Ga)(Al)(In)-Nitrid eingestellt. Die Dotierung kann sich hierbei wie beim MESFET im Volumen befinden oder durch einen Dotierpuls platziert werden wie beim delta-doped MESFET. Auch hier können wieder Isolatoren unter dem Gate zum Einsatz kommen. Auch hier sind normally-off und normally-on Typen möglich. Bei allen genannten Transistortypen können sowohl n- als auch p-Kanaltransistoren realisiert werden.

Vorzugsweise wird die Verschaltung des Halbleiterbauelementes so realisiert, dass sie außer jenem durch die Kontakte und eventuelle Isolierungen zwischen den Kontakten beanspruchten Bereich der Oberfläche möglichst wenig Substratfläche in Anspruch nimmt. Dies kann besonders vorteilhaft erreicht werden, wenn die gemeinsam in einer Ebene angeordneten Kontakte gleicher Funktionen jeweils über eine Kontaktfläche und/oder einen Bus gemeinsam kontaktiert werden, welche über den Kontakten und/oder in der Ebene der Kontakte angeordnet ist. Werden Kontakte gleicher Funktionen über eine gemeinsame Kontaktfläche gemeinsam kontaktiert, so ist diese vorzugsweise parallel zur Ebene, in welcher die Kontakte angeordnet sind, über dieser Ebene angeordnet. Auch ein eventueller Bus, welcher Kontakte gleicher Funktionen elektrisch miteinander verbindet, verläuft vorzugsweise über die Kontakte hinweg, kreuzt diese also und ist gegenüber jenen Kontakten, die er nicht verbindet, elektrisch isoliert. Besonders bevorzugt gibt es für jede in dem Bauelement auftretende Funktion eine Kontaktfläche. Vorzugsweise gibt es also zumindest zwei Kontaktflächen, welche unterschiedliche Funktionen haben bzw. Kontakte zweier unterschiedlicher Funktionen kontaktieren.

Die Kontakte können auch als Elektroden bezeichnet werden bzw. Elektroden sein. Sie können zu einem eventuell vorhandenen Substrat nicht-sperrend bzw. als Ohm-Kontakt oder sperrend bzw. als Schottky-Kontakt ausgebildet sein.

Bei einer gemeinsamen Kontaktierung über Busse und/oder Kontaktflächen ist es bevorzugt, dass zwischen den Kontakten, Bauelementen und/oder Untereinheiten zumindest eine dielektrische Schicht angeordnet ist, welche zumindest eine Öffnung aufweist, durch welche zumindest ein Teil der Kontaktstellen mit der Kontaktfläche, über welche sie gemeinsam kontaktierbar sind, elektrisch kontaktiert sind.

Die dielektrische Schicht ist hierbei vorzugsweise parallel zur Ebene angeordnet, in welcher die Kontakte angeordnet sind. Insbesondere ist diese Schicht vorzugsweise auch unmittelbar auf den Kontakten und/oder den Untereinheiten angeordnet. Die genannten Öffnungen sind vorzugsweise in der Ebene der dielektrischen Schicht angeordnet, erstrecken sich also von der den Kontaktflächen zugewandten Seite der dielektrischen Schicht zu jener dieser gegenüberliegenden, der Baueinheit abgewandten Oberseite. Durch diese Öffnungen sind hierbei zumindest ein Teil der Kontakte, vorzugsweise alle Kontakte, mit jener Kontaktfläche elektrisch in Kontakt, welche die Kontakte der entsprechenden Funktion miteinander verbindet und über welche diese Kontakte gemeinsam von außen kontaktierbar sind. Die entsprechenden Kontaktflächen können hierbei unmittelbar über den genannten Öffnungen angeordnet sein und sich auch so in diese Öffnungen hinein erstrecken, dass sie die unter den Öffnungen liegenden Kontakte berühren, es ist aber auch möglich, dass zwischen der genannten dielektrischen Schicht und den Kontaktflächen weitere Strukturen angeordnet sind, welche den elektrischen Kontakt zwischen den Kontakten und den Kontaktflächen herstellen bzw. vermitteln.

Insbesondere, wenn die Kontaktflächen nicht unmittelbar auf der genannten dielektrischen Schicht angeordnet sind, ist es bevorzugt, dass auf jener den Untereinheiten abgewandten Oberfläche der genannten dielektrischen Schicht zumindest eine leitfähige Schicht angeordnet ist, welche sich über zumindest einen Bereich der Oberfläche der dielektrischen Schicht erstreckt und welche sich so in die zumindest eine Öffnung in der dielektrischen Schicht erstreckt, dass sie mit einer unter der dielektrischen Schicht angeordneten leitfähigen Schicht oder zumindest einem der Kontakte, vorzugsweise mit den Kontakten einer bestimmten Funktion in elektrischem Kontakt steht. Diese leitfähige Schicht kann unmittelbar auf die dielektrische Schicht aufgebracht sein, es sind aber auch Zwischenschichten denkbar. Die leitfähige Schicht kann sich in die Öffnungen erstrecken, indem sie die Öffnungen vollständig oder teilweise auffüllt. Es ist aber auch möglich, dass die leitfähige Schicht nur auf der Oberfläche einer Wandung der Öffnung sowie auf der Oberfläche des unterhalb der Öffnung befindlichen Materials angeordnet ist. Die leitfähige Schicht folgt also der Oberfläche der dielektrischen Schicht, der Wandung der Öffnung sowie dem unterhalb der Öffnung befindlichen Teil der unter der dielektrischen Schicht liegenden Schicht.

Die elektrische Kontaktierung durch die Öffnung kann auch durch gesonderte Via-Kontakte realisiert werden. Derartige Via-Kontakte stehen also unterhalb der jeweiligen dielektrischen Schicht mit der dort angeordneten leitfähigen Schicht bzw. den Kontakten in elektrischem Kontakt bzw. berühren diese und berühren entsprechend eine, beispielsweise die erste leitfähige Schicht, auf der Oberseite der dielektrischen Schicht.

Die vorstehend beschriebene Schichtfolge aus zumindest einer dielektrischen Schicht sowie zumindest einer leitfähigen Schicht kann mehrere Male wiederholt werden, beispielsweise mit einer zweiten und einer dritten dielektrischen Schicht und/oder einer zweiten oder einer dritten leitfähigen Schicht. Auf diese Weise können Kontaktstellen einer Vielzahl von Einzelzellen mit zwei, drei, vier oder mehr verschiedenen Funktionen über eine der Anzahl der Funktionen entsprechende Zahl von Kontaktflächen gemeinsam kontaktiert werden. Die Kontaktflächen können hierbei zusammenhängend in einer gemeinsamen Ebene angeordnet sein und hierbei insbesondere eine Oberfläche der elektrischen Schaltung überdecken. Besonders bevorzugt überdecken die Kontaktflächen eine obere Oberfläche der Schaltung, welche dem Bauelement abgewandt ist, möglichst vollständig. Hierbei kann jedoch zwischen den Kontaktflächen ein gewisser Abstand zur Herstellung einer elektrischen Isolation bestehen, der auch mit dielektrischem Material gefüllt sein kann. Die Form des Halbleiterbauelementes entspricht vorzugsweise der Form eines zugrunde liegenden Substrats, welches vorzugsweise das Substrat ist, auf oder aus welchem die Untereinheiten ausgebildet sein können. Untereinheiten, Bauelement und/oder Substrat können hierbei beispielsweise quadratisch, rechteckig oder kreisförmig sein. Ist die elektrische Schaltung rechteckig, so können die Kontaktflächen vorzugsweise ebenfalls rechteckig sein. Ist die elektrische Schaltung kreisförmig, so können die Kontaktflächen als Sektoren der Kreisfläche, welche durch die elektrische Schaltung definiert wird, ausgebildet sein.

Insbesondere für Dioden und/oder Transistoren ist eine Ausführungsform der elektrischen Schaltung bevorzugt, in welcher die Kontakte verschiedener Funktionen in einer Ebene angeordnet sind. Hierbei ist vorzugsweise über den Kontaktstellen eine erste dielektrische Schicht angeordnet, welche zumindest eine Öffnung über jedem der Kontakte aufweist. Vorzugsweise ist auf dieser ersten dielektrischen Schicht eine erste leitfähige Schicht angeordnet, die für jede der verschiedenen Funktionen zumindest einen Bereich aufweist, wobei die verschiedenen Bereiche der ersten leitfähigen Schicht voneinander elektrisch isoliert sind. Die erste leitfähige Schicht erstreckt sich in den Bereichen so in die Öffnungen, dass sie mit den Kontakten der entsprechenden Funktion in elektrischem Kontakt steht. Die Kontaktierung durch die Öffnung kann hierbei wie oben beschrieben ausgestaltet sein. Die elektrische Kontaktierung durch die Öffnung kann wiederum auch durch gesonderte Via-Kontakte realisiert werden. Derartige Via-Kontakte stehen also unterhalb der dielektrischen Schicht mit der dort angeordneten leitfähigen Schicht bzw. den Kontakten in elektrischem Kontakt bzw. berühren diese und berühren entsprechend die erste leitfähige Schicht auf der Oberseite der dielektrischen Schicht.

Vorzugsweise sind die Bereiche einer leitfähigen Schicht hierbei in einer Ebene angeordnet. Auf der ersten leitfähigen Schicht ist nun vorzugsweise eine zweite dielektrische Schicht angeordnet, welche zumindest zwei, verschiedenen Funktionen entsprechende, Bereiche der ersten leitfähigen Schicht zumindest bereichsweise überdeckt. Diese zweite dielektrische Schicht weist wiederum zumindest eine Öffnung zu den von ihr überdeckten Bereichen der ersten leitfähigen Schicht auf, durch welche die erste leitfähige Schicht von jener der ersten leitfähigen Schicht abgewandten Seite der zweiten dielektrischen Schicht aus kontaktierbar ist. Vorzugsweise ist auf der zweiten dielektrischen Schicht zumindest eine zweite leitfähige Schicht mit vorzugsweise verschiedenen getrennten Bereichen angeordnet, welche durch die Öffnungen in der zweiten dielektrischen Schicht mit jeweils einem der darunterliegenden Bereiche der ersten leitfähigen Schicht in elektrischem Kontakt steht. Diese Kontaktierung kann wiederum durch direkten Kontakt oder auch über einen Via-Kontakt hergestellt sein.

Insbesondere, wenn die Einheitszellen mehr als zwei verschiedene Funktionen aufweisen, ist es besonders bevorzugt, dass auf der zweiten leitfähigen Schicht eine dritte dielektrische Schicht angeordnet ist, welche wiederum zumindest eine Öffnung aufweist, durch welche zumindest ein Bereich der zweiten leitfähigen Schicht kontaktierbar ist. Auf der dritten dielektrischen Schicht kann dann eine dritte leitfähige Schicht oder zumindest eine Kontaktfläche angeordnet sein, welche mit zumindest einem Bereich zumindest einen Bereich der zweiten leitfähigen Schicht durch die zumindest eine Öffnung in der dritten dielektrischen Schicht kontaktiert. Durch die vorstehend beschriebene Anordnung ist es besonders vorteilhaft möglich, eine im Wesentlichen unbegrenzte Vielzahl von vorzugsweise gleichartigen Einheitszellen mit Kontakten zweier oder dreier verschiedener Funktionen über für jede Funktion eine Kontaktfläche gemeinsam zu kontaktieren.

Die genannten Öffnungen in allen der beschriebenen dielektrischen Schichten können verschiedene Geometrien haben. Die Öffnungen können zylinderförmig sein mit einem kreisförmigen, rechteckigen oder anders geformten Querschnitt auf der Ober- und der Unterseite der entsprechenden dielektrischen Schicht. Besonders bevorzugt sind jedoch auch längliche Öffnungen, die sich, insbesondere bei länglichen Kontakten bzw. länglichen Elektroden, zumindest abschnittsweise parallel zu den Kontakten bzw. Elektroden länglich erstrecken.

Eine besonders bevorzugte Ausführungsform sieht vor, dass das Substrat und die elektrische Schaltung kreisförmig sind. Hierbei sind besonders bevorzugt zumindest einige der Kontakte kreisringförmig oder als Abschnitte von Kreisringen ausgestaltet und parallel zueinander angeordnet. Die genannten Öffnungen in dielektrischen Schichten sind hierbei vorzugsweise ebenfalls als Abschnitte von Kreisringen ausgestaltet und verlaufen parallel zu den Kontaktstellen. Die Kontaktflächen sind vorzugsweise als Sektoren der kreisförmigen Oberfläche der Schaltung ausgestaltet.

Vorzugsweise weisen ein oder mehrere der Kontaktflächen jeweils zumindest einen Bondfleck auf, an welchem besonders bevorzugt zumindest ein Bonddraht angeordnet ist.

Die oben beschriebenen dielektrischen und/oder leitfähigen Schichten und/oder Kontaktflächen sind vorzugsweise flächig so ausgestaltet, dass sie in Beschichtungsverfahren herstellbar sind. Sie können also vorzugsweise Beschichtungen der jeweils darunter liegenden Fläche oder Schicht sein.

Für jede Funktion kann genau eine Kontaktfläche vorgesehen sein.

Es kann ein Verbraucher vorgesehen sein, der den Source-Kontakt der ersten Transistoren und/oder den Drain-Kontakt der zweiten Transistoren elektrisch kontaktiert, vorzugsweise elektrisch unmittelbar kontaktiert.

Die Transistoren können u.a. Feldeffekttransistoren sein.

Zumindest eine leitfähige Schicht und/oder zumindest eine dielektrische Schicht und/oder zumindest ein Substrat kann vorzugsweise durch Photolithographie und/oder Ätzen und/oder in einem chemical vapour deposition-Verfahren und/oder in einem physical vapour deposition-Verfahren hergestellt werden.

Die erfindungsgemäß verschachtelte Anordnung der Kontakte hat den Vorteil, dass der thermische Widerstand, den ein einzelner Kontakt erfährt, reduziert wird. Sind, wie beispielsweise bei einer H-Brücke, zu jedem Zeitpunkt nur Kontakte mit einer Funktion mit Strom beaufschlagt, ist dessen Energieeintrag pro Fläche deutlich geringer. Durch den reduzierten thermischen Widerstand wird die Temperatur des Bauelementes reduziert, wodurch wiederum der nicht gewollte Serienwiderstand reduziert wird und dessen Leistungseintrag in das Bauelement verringert wird. Durch die geringere Aufwärmung ergibt sich auch der Vorteil, dass ein für gleiche Leistung wie im Stand der Technik geeignetes Bauelement insgesamt nur eine kleinere Fläche notwendig ist. Die verschachtelte Anordnung hat weiter den Vorteil, dass Substratströme, die durch angezogene Spiegelladungen hervorgerufen werden, sich im Mittel auf einer kleineren Halbleiterfläche neutralisieren können, so dass benachbarte Untereinheiten auf demselben Substrat bei einer gegebenen Integrationsdichte weniger gestört werden. Auf diese Weise lässt sich bei einem vorgegebenen Störniveau die Integrationsdichte weiter erhöhen.

Im Folgenden soll die Erfindung beispielhaft anhand von Figuren näher erläutert werden.

Es zeigt
- Figur 1: eine Kontaktierung eines Bauelementes mit einer Vielzahl von gleichartigen Untereinheiten nach dem Stand der Technik;
- Figur 2: ein Halbleiterbauelement mit einer Vielzahl von Untereinheiten entsprechend der vorliegenden Erfindung;
- Figur 3: ein Schaltbild einer vollen H-Brücke.

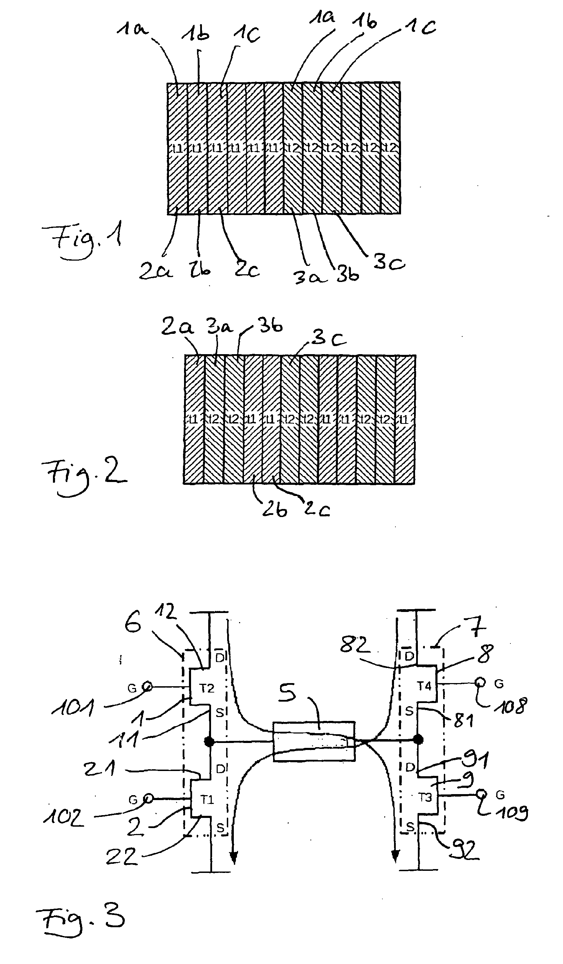

Figur 1 zeigt ein Halbleiterbauelement mit einer halben H-Brücke entsprechend dem Stand der Technik. Die halbe H-Brücke weist hierbei eine Vielzahl von Untereinheiten 1a, 1b, 1c auf, in denen jeweils der Source-Kontakt eines ersten Transistors mit einem Drain-Kontakt eines zweiten Transistors verbunden ist. In der Figur zu sehen sind die Drain-Kontakte 2a, 2b, 2c der ersten Transistoren sowie die Source-Kontakte 3a, 3b, 3c der zweiten Transistoren. Die Kontakte 2a, 2b, 2c, 3a, 3b, 3c sind hierbei gerade und länglich ausgestaltet und zueinander parallel auf einem Substrat in einer Ebene angeordnet. Die Kontakte 2a, 2b, 2c, 3a, 3b, 3c grenzen unmittelbar aneinander, wobei zwischen aneinander grenzenden Drain-Kontakten der ersten Transistoren und Source-Kontakten der zweiten Transistoren eine Isolation angeordnet sein kann. Es ist zu erkennen, dass alle Drain-Kontakte 2a, 2b, 2c des ersten Transistors auf einer Hälfte des Substrates angeordnet sind, während alle Source-Kontakte des zweiten Transistors 3a, 3b, 3c auf der gegenüber liegenden zweiten Hälfte des Bauelementes angeordnet sind.

Figur 2 zeigt eine Anordnung entsprechend Figur 1, wie sie gemäß der vorliegenden Erfindung ausgestaltet ist. Wiederum handelt es sich um eine halbe H-Brücke mit einer Vielzahl von Untereinheiten 1a, 1b, 1c, wobei die Kontakte 2a, 2b, 2c, 3a, 3b, 3c des ersten und zweiten Transistors unmittelbar aneinander angrenzend länglich, gerade und zueinander parallel in einer Ebene angeordnet sind. Wiederum kann zwischen Kontakten des ersten 1 und des zweiten Transistors 2 eine Isolation angeordnet sein. Hier ist nun unmittelbar benachbart zu jedem Kontakt einer Funktion ein Kontakt einer anderen Funktion angeordnet, nämlich benachbart zum Kontakt 2a des zweiten Transistors der Kontakt 3a des ersten Transistors, welcher auf seiner dem Kontakt 2a abgewandten Seite an den Kontakt 3b eines der ersten Transistoren grenzt. Der Kontakt 3b wiederum grenzt an Kontakt 2b eines der zweiten Transistoren, der seinerseits wieder an Kontakt 2c eines der zweiten Transistoren grenzt. Die Kontakte sind also ineinander verschachtelt bzw. abwechselnd angeordnet. Das Substrat, auf welchem die Kontakte 2a, 2b, 2c, 3a, 3b, 3c angeordnet sind, kann vorteilhafterweise halbleitend oder leitend sein. Im gezeigten Beispiel ist es rechteckig. Die gezeigten Kontakte können über Kontaktflächen, die hier nicht eingezeichnet sind, für jede Funktion jeweils gemeinsam kontaktiert werden. Hierbei kann zwischen den Elektroden 2a, 2b, 2c, 3a, 3b, 3c und den entsprechenden Kontaktflächen ein oder mehrere leitfähige Schichten und/oder ein oder mehrere dielektrische Schichten angeordnet sein, wobei die dielektrischen Schichten Öffnungen aufweisen können, die eine elektrische Durchkontaktierung zwischen Bereichen der leitfähigen Schichten und/oder Kontaktflächen und entsprechenden Kontakten ermöglichen.

Alternativ zum gezeigten Beispiel können die Kontakte 2a, 2b, 2c, 3a, 3b, 3c beispielsweise auch als konzentrische Kreise abwechselnd auf einem kreisförmigen Substrat angeordnet sein. Eventuelle Kontaktflächen können hier als Sektoren einer Kreisfläche ausgebildet sein, welche parallel zum Substrat über diesem angeordnet ist.

Figur 3 zeigt eine Schaltung einer H-Brücke, wie sie in der vorliegenden Erfindung realisiert sein kann. Die H-Brücke weist zwei halbe H-Brücken 6 und 7 auf. Die halbe H-Brücke 6 weist einen ersten Transistor 1 und einen zweiten Transistor 2 auf. Ein Source-Kontakt 11 des ersten Transistors 1 ist mit einem Drain-Kontakt 21 des zweiten Transistors 2 elektrisch unmittelbar kontaktiert. Ein Verbraucher 5 ist mit dem Source-Kontakt 11 des ersten Transistors 1 und dem Drain-Kontakt 21 des zweiten Transistors 2 in Kontakt. Eine Versorgungsspannung wird hierbei zwischen einem Drain-Kontakt 12 des ersten Transistors 1 und einem Source-Kontakt 22 des zweiten Transistors 2 angelegt. Auch die zweite halbe H-Brücke 7 weist einen ersten Transistor 8 und einen zweiten Transistor 9 auf, die analog zu den Transistoren 1 und 2 verschaltet sind. Der Verbraucher 5 ist wiederum mit dem Source-Kontakt 81 des ersten Transistors 8 sowie mit dem Drain-Kontakt 91 des zweiten Transistors 9 verbunden. Die Versorgungsspannung wird hier zwischen dem Drain-Kontakt 82 des ersten Transistors 8 und dem Source-Kontakt 92 des zweiten Transistors 9 angelegt. Transistor 1 kann über ein Gate 101 angesteuert werden, der Transistor 2 kann über ein Gate 102 angesteuert werden, Transistor 8 kann über ein Gate 108 angesteuert werden und Transistor 9 kann über ein Gate 109 angesteuert werden. Wird nun der erste Transistor 1 der halben H-Brücke 6 geöffnet und der zweite Transistor 2 der ersten halben H-Brücke 6 geschlossen, der erste Transistor 8 der zweiten halben H-Brücke geschlossen und der zweite Transistor 9 dieser zweiten halben H-Brücke geöffnet, so fließt ein Strom aus Richtung der halben H-Brücke 6 in Richtung der halben H-Brücke 7 durch den Verbraucher 5. Werden hingegen die Transistoren 8 und 2 geöffnet, während die Transistoren 1 und 9 geschlossen werden, so fließt der Strom in entgegen gesetzter Richtung von der halben H-Brücke 7 zur halben H-Brücke 6 durch den Verbraucher 5. Durch Anlegen einer entsprechenden Spannung an die Gates 101, 102, 108 und 109 kann also die Richtung des Stromflusses durch den Verbraucher 5 variiert werden. In der vorliegenden Erfindung kann entweder eine halbe H-Brücke auf einem Substrat und die andere halbe H-Brücke auf einem anderen Substrat realisiert sein, es ist aber auch möglich, dass beide H-Brücken 6 und 7 auf einem gemeinsamen Substrat realisiert sind.

## Patentansprüche

1. Halbleiterbauelement mit zumindest einer Baueinheit, wobei die zumindest eine Baueinheit eine Vielzahl von gleichartigen Untereinheiten mit jeweils zumindest zwei Kontakten unterschiedlicher Funktionen aufweist, wobei die Kontakte zumindest zweier Funktionen auf einer gemeinsamen Fläche nebeneinander angeordnet sind, und
wobei unmittelbar benachbart zu jedem Kontakt einer Funktion zumindest ein Kontakt einer anderen Funktion angeordnet ist,
**dadurch gekennzeichnet, dass** die Untereinheiten jeweils zwei Transistoren aufweisen, wobei ein Source-Kontakt eines ersten der Transistoren mit einem Drain-Kontakt eines zweiten der Transistoren elektrisch kontaktiert ist und wobei die Kontakte die Funktionen Drain des ersten Transistors, Source des zweiten Transistors, Gate des ersten Transistors und Gate des zweiten Transistors haben.

2. Halbleiterbauelement nach dem vorhergehenden Anspruch,
**dadurch gekennzeichnet, dass** zumindest ein Teil oder alle der nebeneinander angeordneten Kontakte länglich ausgebildet sind und/oder parallel zueinander angeordnet sind und/oder ringförmig geschlossen sind und/oder in einer Ebene angeordnet sind und/oder auf einem gemeinsamen Substrat angeordnet sind, welches vorzugsweise leitend oder halbleitend ist.

3. Halbleiterbauelement nach einem der vorhergehenden Ansprüche,
**dadurch gekennzeichnet, dass** die unmittelbar benachbarten Kontakte unmittelbar oder über eine Isolierung unmittelbar aneinander angrenzend angeordnet sind.

4. Halbleiterbauelement nach einem der vorhergehenden Ansprüche,
**dadurch gekennzeichnet, dass** die zumindest eine Baueinheit so ausgestaltet ist, dass im Betrieb nicht durch Kontakte aller Funktionen der unmittelbar benachbarten Kontakte, vorzugsweise nur durch Kontakte nur einer Funktion, gleichzeitig ein Strom fließt.

5. Halbleiterbauelement nach einem der vorhergehenden Ansprüche,
**dadurch gekennzeichnet, dass** die Untereinheiten halbe H-Brücken sind.

6. Halbleiterbauelement nach einem der vorhergehenden Ansprüche,
**dadurch gekennzeichnet, dass** der Source-Kontakt des ersten der Transistoren mit dem Drainkontakt des zweiten der Transistoren elektrisch unmittelbar kontaktiert ist.

7. Halbleiterbauelement nach dem vorhergehenden Anspruch,
**dadurch gekennzeichnet, dass** die unmittelbar benachbart angeordneten Kontakte die Drain-Kontakte des ersten Transistors und die Source-Kontakte des zweiten Transistors sind.

8. Halbleiterbauelement nach einem der vorhergehenden Ansprüche,
**dadurch gekennzeichnet, dass** zumindest eine der Baueinheiten ein Nitrid eines Hauptgruppe-III-Elementes aufweist.

9. Halbleiterbauelement nach einem der vorhergehenden Ansprüche,
**dadurch gekennzeichnet, dass** die gemeinsam in einer Ebene angeordneten Kontakte gleicher Funktion über zumindest eine Kontaktfläche und/oder zumindest einen Bus, welche parallel zur Ebene, in welcher die Kontaktstellen angeordnet sind, angeordnet ist, vorzugsweise über dieser Ebene, gemeinsam von außen kontaktierbar sind.

10. Halbleiterbauelement nach dem vorhergehenden Anspruch,
**dadurch gekennzeichnet, dass** zwischen den Kontakten und zumindest einer der Kontaktflächen zumindest eine dielektrische Schicht angeordnet ist, welche zumindest eine Öffnung aufweist, durch welche zumindest ein Teil der Kontakte mit der Kontaktfläche, über welche sie gemeinsam kontaktierbar sind, elektrisch kontaktiert sind.

11. Halbleiterbauelement nach einem der beiden vorhergehenden Ansprüche,
**dadurch gekennzeichnet, dass** auf jener den Kontakten abgewandten Oberfläche der zumindest einen dielektrischen Schicht zumindest eine leitfähige Schicht angeordnet ist, welche sich über zumindest einen Bereich dieser Oberfläche erstreckt und welche sich so in die zumindest eine Öffnung erstreckt, dass sie mit einer unter der dielektrischen Schicht angeordneten leitfähigen Schicht oder einer der Kontaktflächen in elektrischem Kontakt steht.

12. Halbleiterbauelement nach einem der drei vorhergehenden Ansprüche,
**dadurch gekennzeichnet, dass** über den Kontakten eine erste dielektrische Schicht angeordnet ist, welche jeweils zumindest eine Öffnung über jedem der benachbarten Kontakte aufweist,
dass auf der ersten dielektrischen Schicht für jede Funktion zumindest ein Bereich einer ersten leitfähigen Schicht angeordnet ist, welche sich so in die Öffnungen erstreckt, dass sie mit den Kontakten der entsprechenden Funktion in elektrischem Kontakt steht, wobei vorzugsweise die Bereiche der ersten leitfähigen Schicht in einer Ebene angeordnet sind und wobei Bereiche unterschiedlicher Funktionen elektrisch voneinander getrennt sind,
dass auf der ersten leitfähigen Schicht eine zweite dielektrische Schicht angeordnet ist, welche zumindest zwei Funktionen entsprechende Bereiche der ersten leitfähigen Schicht zumindest bereichsweise überdeckt, und zumindest eine Öffnung zu jedem der von ihr überdeckten Bereiche der ersten leitfähigen Schicht aufweist, dass auf der zweiten dielektrischen Schicht zumindest eine zweite leitfähige Schicht angeordnet ist, welche durch die Öffnungen in der zweiten dielektrischen Schicht zumindest einen der darunter liegenden Bereiche der ersten leitfähigen Schichten in zumindest einem Bereich kontaktiert.

13. Halbleiterbauelement nach einem der vier vorhergehenden Ansprüche,
**dadurch gekennzeichnet, dass** die Untereinheiten auf einem kreisflächenförmigen Substrat angeordnet sind, dass die Kontakte zumindest teilweise als zumindest Abschnitte von Kreisringen ausgestaltet sind und/oder dass die Kontaktflächen als Sektoren, vorzugsweise als Halbe oder Drittel, einer Kreisfläche ausgestaltet sind, die mit im Wesentlichen gleichen Abmessungen wie das Substrat zu diesem parallel angeordnet sind.

14. Halbleiterbauelement nach einem der Ansprüche 1 bis 13,
**dadurch gekennzeichnet, dass** zumindest eine der Kontaktflächen zumindest einen eine Kontaktfläche kontaktierenden Bondfleck zum Kontaktieren der elektrischen Schaltung mittels eines Bonddrahtes und/oder zumindest einen Bonddraht aufweist, wobei vorzugsweise der Bondfleck und/oder der Bonddraht auf einer den Einheitszellen abgewandten Oberseite der entsprechenden Kontaktfläche angeordnet ist.

15. Verfahren zur Herstellung eines Halbleiterbauelementes,
**dadurch gekennzeichnet, dass** ein Halbleiterbauelement nach einem der Ansprüche 1 bis 14 hergestellt wird.

## Claims

1. Semiconductor component having at least one constructional unit, the at least one constructional unit having a large number of similar subunits with respectively at least two contacts of different functions, the contacts of at least two functions being disposed adjacently on a common surface, and wherein there is disposed, directly adjacent to each contact of one function, at least one contact of another function,
**characterised in that** the subunits have respectively two transistors, a source contact of a first of the transistors being contacted electrically with a drain contact of a second of the transistors, and the contacts having the functions drain of the first transistor, source of the second transistor, gate of the first transistor and gate of the second transistor.

2. Semiconductor component according to the preceding claim,
**characterised in that** at least a part or all of the adjacently disposed contacts have an oblong configuration and/or are disposed parallel to each other and/or are annularly closed and/or are disposed in one plane and/or are disposed on a common substrate which is preferably conducting or semiconducting.

3. Semiconductor component according to one of the preceding claims,
**characterised in that** the directly adjacent contacts are disposed directly or via insulation abutting directly against each other.

4. Semiconductor component according to one of the preceding claims,
**characterised in that** the at least one constructional unit is configured such that, during operation, a current flows not through contacts of all of the functions of the directly adjacent contacts, preferably only through contacts of only one function, at the same time.

5. Semiconductor component according to one of the preceding claims,
**characterised in that** the subunits are half H-bridges.

6. Semiconductor component according to one of the preceding claims,
**characterised in that** the source contact of the first of the transistors being contacted electrically directly with the drain contact of the second of the transistors

7. Semiconductor component according to the preceding claim,
**characterised in that** the directly adjacently disposed contacts are the drain contacts of the first transistor and the source contacts of the second transistor.

8. Semiconductor component according to one of the preceding claims,
**characterised in that** at least one of the construction units has a nitride of a main group III element.

9. Semiconductor component according to one of the preceding claims,
**characterised in that** the contacts of the same function disposed in common in one plane can be contacted in common from outside via at least one contact surface and/or at least one bus, which is disposed parallel to the plane in which the contact points are disposed, preferably above this plane.

10. Semiconductor component according to the preceding claim,
**characterised in that** there is disposed between the contacts and at least one of the contact surfaces, at least one dielectric layer which has at least one opening through which at least a part of the contacts are contacted electrically with the contact surface via which they can be contacted in common.

11. Semiconductor component according to one of the two preceding claims,
**characterised in that**, on that surface of the at least one dielectric layer, orientated away from the contacts, at least one conductive layer is disposed, which extends over at least one region of this surface and which extends into the at least one opening such that it is in electrical contact with a conductive layer which is disposed under the dielectric layer or with one of the contact surfaces.

12. Semiconductor component according to one of the three preceding claims,
**characterised in that** above the contacts, a first dielectric layer is disposed, which has respectively at least one opening above each of the adjacent contacts,
**in that** at least one region of a first conductive layer is disposed on the first dielectric layer for each function, which first conductive layer extends into the openings such that it is in electrical contact with the contacts of the corresponding function, the regions of the first conductive layer preferably being disposed in one plane and regions of different functions being separated from each other electrically,
**in that**, on the first conductive layer, a second dielectric layer is disposed, which covers regions of the first conductive layer corresponding to at least two functions, at least in regions and has at least one opening to each of the regions of the first conductive layer which are covered by it,
**in that** at least one second conductive layer is disposed on the second dielectric layer, which second conductive layer contacts through the openings in the second dielectric layer at least one of the regions of the first conductive layers situated thereunder in at least one region.

13. Semiconductor component according to one of the four preceding claims,
**characterised in that** the subunits are disposed on a circular area-shaped substrate, **in that** the contacts are configured at least partially as at least portions of circular rings and/or **in that** the contact surfaces are configured as sectors, preferably as half or third, of a circular area, which are disposed with essentially the same dimensions as the substrate parallel to the latter.

14. Semiconductor component according to one of the claims 1 to 13,
**characterised in that** at least one of the contact surfaces has at least one bonding spot contacting a contact surface for contacting the electrical circuit by means of a bonding wire and/or at least one bonding wire, the bonding spot and/or the bonding wire preferably being disposed on an upper side of the corresponding contact surface orientated away from the unit cells.

15. Method for producing a semiconductor component,
**characterised in that** a semiconductor component according to one of the claims 1 to 14 is produced.

## Revendications

1. Composant semi-conducteur avec au moins une unité formant module, dans lequel la au moins une unité formant module présente une pluralité de sous-unités similaires avec respectivement au moins deux contacts avec des fonctions différentes, dans lequel les contacts avec au moins deux fonctions sont agencés l'un à côté de l'autre sur une surface commune, et dans lequel dans le voisinage immédiat de chaque contact avec une fonction est agencé au moins un contact avec une autre fonction, **caractérisé en ce que** les sous-unités présentent respectivement deux transistors, dans lequel un contact de source d'un premier des transistors est en contact électrique avec un contact de drain d'un deuxième des transistors, et dans lequel les contacts ont les fonctions drain du premier transistor, source du deuxième transistor, grille du premier transistor et grille du deuxième transistor.

2. Composant semi-conducteur selon la revendication précédente, **caractérisé en ce qu'**au moins une partie ou la totalité des contacts agencés les uns à côté des autres ont une configuration oblongue, et/ou sont agencés parallèlement les uns aux autres et/ou sont fermés en forme d'anneau et/ou sont agencés dans un plan et/ou sont agencés sur un substrat commun, lequel est de préférence conducteur ou semi-conducteur.

3. Composant semi-conducteur selon l'une des revendications précédentes, **caractérisé en ce que** les contacts immédiatement voisins sont agencés de manière adjacente les uns par rapport aux autres, directement ou directement via une isolation.

4. Composant semi-conducteur selon l'une des revendications précédentes, **caractérisé en ce que** la au moins une unité formant module est configurée de telle sorte que, en fonctionnement, un courant s'écoule simultanément non par des contacts avec toutes les fonctions des contacts immédiatement voisins, mais de préférence seulement par des contacts avec une seule fonction.

5. Composant semi-conducteur selon l'une des revendications précédentes, **caractérisé en ce que** les sous-unités sont des demi-ponts en H.

6. Composant semi-conducteur selon l'une des revendications précédentes, **caractérisé en ce que** le contact de source du premier des transistors est en contact électrique immédiat avec le contact de drain du deuxième des transistors.

7. Composant semi-conducteur selon la revendication précédente, **caractérisé en ce que** les contacts agencés de manière immédiatement voisine sont les contacts de drain du premier transistor et les contacts de source du deuxième transistor.

8. Composant semi-conducteur selon l'une des revendications précédentes, **caractérisé en ce qu'**au moins une des unités formant module présente un nitrure d'un élément du troisième groupe principal.

9. Composant semi-conducteur selon l'une des revendications précédentes, **caractérisé en ce que** les contacts avec une même fonction agencés ensemble dans un plan peuvent être mis en contact ensemble à partir de l'extérieur via au moins une surface de contact et/ou au moins un bus, laquelle est agencée parallèlement au plan dans lequel sont agencés les points de contact, de préférence via ce plan.

10. Composant semi-conducteur selon la revendication précédente, **caractérisé en ce qu'**au moins une couche diélectrique est agencée entre les contacts et au moins une des surfaces de contact, laquelle couche diélectrique présente au moins une ouverture à travers laquelle au moins une partie des contacts est en contact électrique avec la surface de contact, via laquelle ils peuvent être mis en contact ensemble.

11. Composant semi-conducteur selon l'une des deux revendications précédentes, **caractérisé en ce que** sur la surface, opposée aux contacts, de la au moins une couche diélectrique est agencée au moins une couche conductrice qui s'étend sur au moins une zone de cette surface et qui s'étend dans la au moins une ouverture de telle sorte qu'elle soit en contact électrique avec une couche conductrice agencée sous la couche diélectrique, ou avec l'une des surfaces de contact.

12. Composant semi-conducteur selon l'une des trois revendications précédentes, **caractérisé en ce qu'**au-dessus des contacts est agencée une première couche diélectrique qui présente respectivement au moins une ouverture au-dessus de chacun des contacts voisins, **en ce que** sur la première couche diélectrique et pour chaque fonction est agencée au moins une zone d'une première couche conductrice qui s'étend dans les ouvertures de telle sorte qu'elle soit en contact électrique avec les contacts de la fonction correspondante, dans lequel de préférence les zones de la première couche conductrice sont agencées dans un plan, et dans lequel des zones avec des fonctions différentes sont électriquement séparées les unes des autres, **en ce que** sur la première couche conductrice est agencée une deuxième couche diélectrique qui recouvre au moins partiellement des zones, correspondant à au moins deux fonctions, de la première couche conductrice et qui présente au moins une ouverture vers chacune des zones, recouvertes par elle, de la première couche conductrice, **en ce que**, sur la deuxième couche diélectrique est agencée au moins une deuxième couche conductrice qui, par les ouvertures aménagées dans la deuxième couche diélectrique, est en contact avec une des zones, situées en dessous, des premières couches conductrices dans au moins une zone.

13. Composant semi-conducteur selon l'une des quatre revendications précédentes, **caractérisé en ce que** les sous-unités sont agencées sur un substrat de forme de surface circulaire, **en ce que** les contacts sont au moins partiellement configurés comme au moins des tronçons d'anneaux circulaires, et/ou **en ce que** les surfaces de contact sont configurées comme des secteurs, de préférence comme des moitiés ou des tiers, d'une surface circulaire qui sont agencés avec sensiblement les mêmes dimensions que le substrat, et parallèlement à ce dernier.

14. Composant semi-conducteur selon l'une des revendications 1 à 13, **caractérisé en ce qu'**au moins une des surfaces de contact présente au moins un plot de connexion, destiné à entrer en contact avec une surface de contact, pour entrer en contact avec le circuit électrique à l'aide d'un fil de connexion, et/ou au moins un fil de connexion, dans lequel de préférence le plot de connexion et/ou le fil de connexion est agencé sur une face supérieure, opposée aux cellules d'unité, de la surface de contact correspondante.

15. Procédé de fabrication d'un composant semi-conducteur, **caractérisé en ce qu'**est fabriqué un composant semi-conducteur selon l'une des revendications 1 à 14.
